# EUROPEAN PATENT APPLICATION

(11) **EP 4 572 560 A1**
(43) Date of publication of application: **18.06.2025**
(21) Application number: 24315551.2
(22) Date of filing: 05.12.2024
(51) Int. Cl.: H10D 30/01, H01L 21/321

(54) **MANUFACTURING METHOD OF A SEMICONDUCTOR ELECTRONIC DEVICE WITH TRENCH GATE**

(30) Priority: 12.12.2023 IT 202300026448
(71) Applicant: STMicroelectronics International N.V., 1228 Plan-les-Ouates, Geneva (CH)
(72) Inventor: Pistoni, Mario Francesco, 20142 MILANO (IT); Mariani, Simone Dario, 20854 VEDANO AL LAMBRO (MB) (IT); Zuliani, Paola, 20147 MILANO (IT); Prevost, Emilie, 38000 GRENOBLE (FR); Pisanu, Ambra, 38000 GRENOBLE (FR)
(74) Representative: Studio Torta S.p.A.

(57) **Abstract**

A method of manufacturing an electronic device, comprising the steps of: forming, on a first side (102a) of a solid body (101, 102) of Silicon, a first covering layer (104a) of SiO₂; forming, on the first covering layer (104a), a second covering layer (104b) of SiN; forming, on the second covering layer (104b), a third covering layer (104c) of TEOS; forming a passing opening through the first, second and third covering layers (104a-104c); forming a trench (106) at the portion of the solid body exposed through the opening; grow a sacrificial layer (114), of said first oxide, within the trench (106); and perform in the order: selectively etch part of the second covering layer (104b), completely remove the sacrificial layer (114) and the third covering layer (104c) in one or more contextual etching steps.

## Description

The present invention relates to a method for manufacturing a semiconductor electronic device with trench gate.

Vertical-conduction power MOSFETs are known to have a trench-gate region, extending in depth in a semiconductor body and comprising a conductive region, of doped polysilicon, surrounded and electrically insulated from the semiconductor body by a dielectric region (made, for example, of silicon oxide - SiO₂).

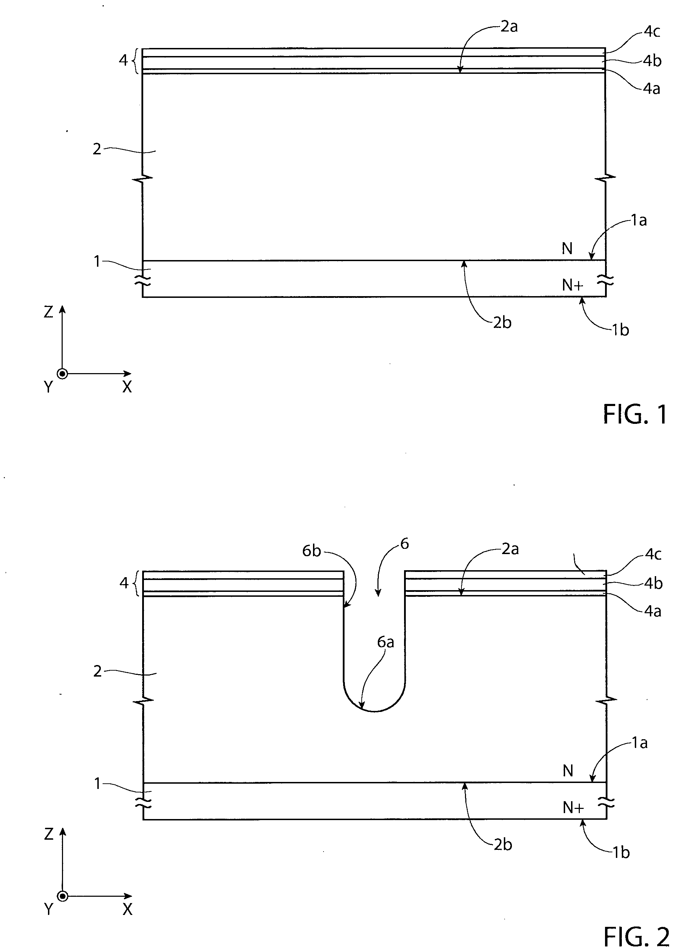

A process, which is not necessarily prior art, is disclosed with reference to Figures 1-7. Figures 1-7 are illustrated in a triaxial reference system of orthogonal axis X, Y, Z.

Figure 1 illustrates a wafer comprising a substrate 1 of silicon, having a first conductivity (N-type) and a doping concentration. The substrate 1 is delimited on a first side 1a and on a second side 1b opposite to one another along the axis Z.

On the substrate 1, a structural layer or region 2 is formed, for example by epitaxial growth of silicon, having the first conductivity (N) and a respective concentration of dopants. The substrate 1 and the structural region 2 form, together, a semiconductor body having a thickness, along Z, approximately between 700 um and 800 um.

The semiconductor body has a first side 2a opposite to a second side 1b, in the Z direction.

On the first side 2a of the structural layer 2, a multilayer 4 is formed, which includes a first layer 4a, in contact with the first side 2a, for example, of silicon oxide grown via thermal oxidation with a thickness comprised between 5 nm and 100 nm; a second layer 4b immediately on top of the first layer 4a, for example of silicon nitride with a thickness comprised between 10 nm and 20 nm; and a third layer 4c, immediately on top of the second layer 4b, for example of TEOS with a thickness comprised between 300 nm and 500 nm. The first layer 4a has the function of forming an adhesion interface between the structural layer 2, of silicon, and the second layer 4b, of silicon nitride, in order to prevent mechanical stress induced by silicon nitride and prevent nitriding of the surface of the silicon itself, which jeopardises operation of the device. The second layer 4b forms a hard mask for a subsequent step of etching of the structural layer 2 to form the trenches for the gate region; it also has the purpose to prevent oxidation where not needed as well the erosion of the silicon itself during a subsequent Chemical Mechanical Polishing process. The third layer 4c forms a hard mask for the step of etching of the structural layer 2.

With reference to Figure 2, by photolithographic technique, the multilayer 4 is removed in regions of the wafer where the trench gate is to be formed. A dry etching of the semiconductor body is carried out, for example RIE, for selective removal of portions of the structural layer 2 exposed through the multilayer 4 and so as to form a trench 6 delimited by a bottom wall 6a and side walls 6b. The trench 6 has a depth, measured starting from the first side 2a of the structural layer 2 comprised, for example, between 4 and 6 um.

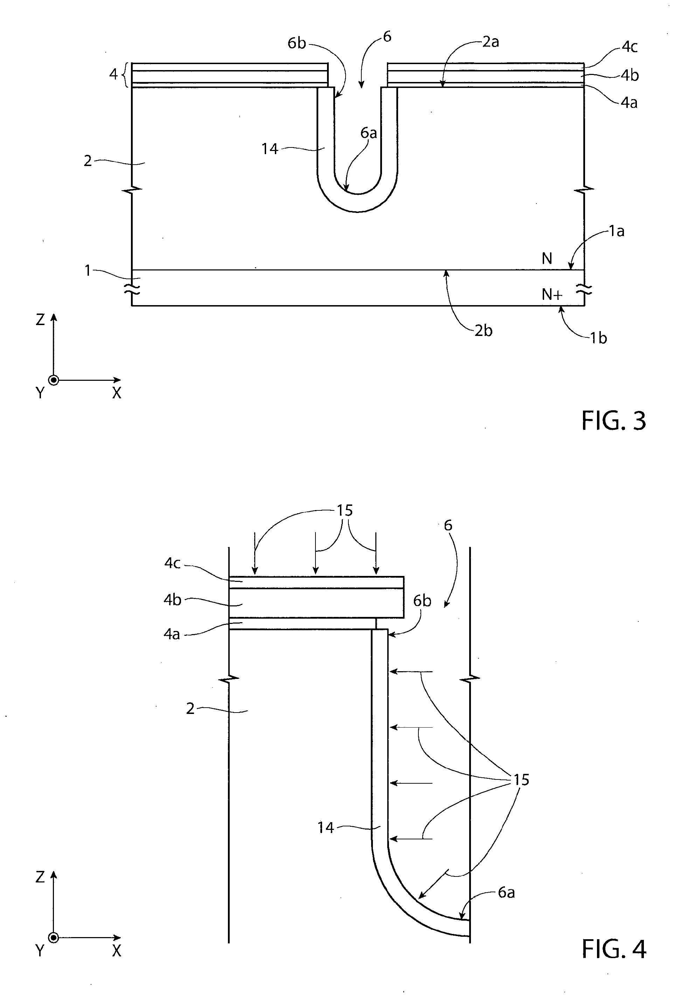

Then, Figure 3, a thermal oxidation process is then carried out, to form a sacrificial oxide layer 14 within the trench 6, on the lateral and bottom walls 6a, 6b. The formation of the sacrificial oxide layer 14 involves partial conversion of the silicon of semiconductor body into silicon oxide. As described later, removal of this sacrificial oxide layer 14 allows to smoothen the lateral and bottom silicon walls 6a, 6b, which might have been rendered rough by the etching step.

Next, Figure 4 (which is an enlarged view of part of Figure 3), the sacrificial oxide layer 14 within the trench 6 is partially etched, until a thickness of about 80 nm is reached for the sacrificial oxide layer 14. During this etching step, also the third layer 4c (of TEOS) is etched (arrows 15), and its thickness is therefore reduced correspondingly. The thickness of the third layer 4c is chosen such that it is not completely removed during the partial etching step of the sacrificial oxide layer 14, as shown in Figure 4.

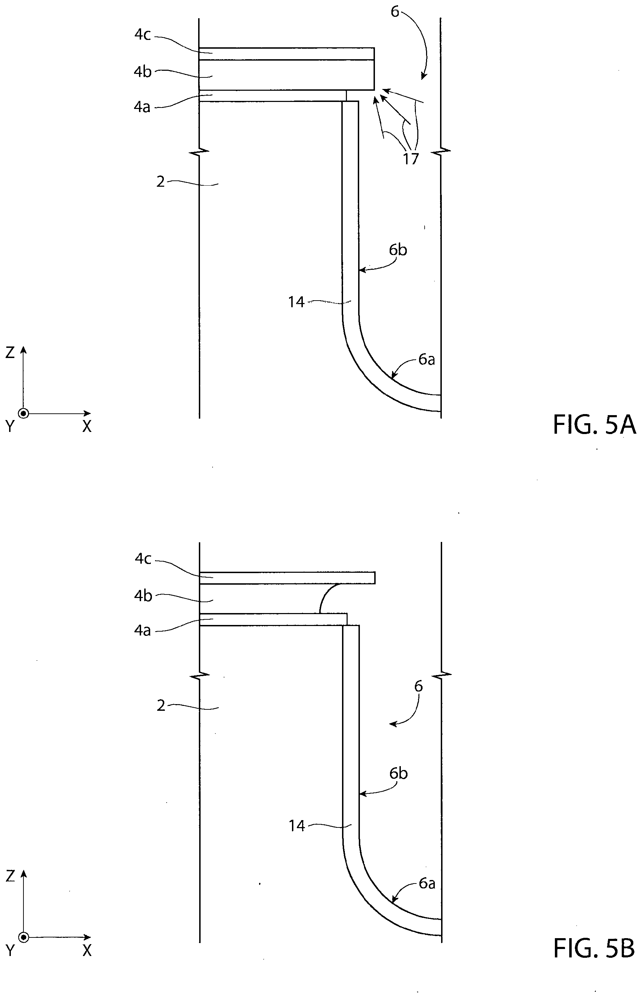

Then, Figure 5A, a step of etching the second layer 4b is carried out, using an etching chemistry that selectively removes the silicon nitride material of the second layer 4b with respect to the silicon oxide and TEOS. The etching of the second layer 4b is a wet etching that removes isotropically the second layer 4b; the etching proceeds as shown by arrows 17 in Figure 5A (faster from bottom side of the second layer 4b), shaping the second layer 4b as illustrated in Figure 5B. In other words, the second layer 4b has, after etching, a curved shape with a final negative profile, which is detrimental for the later gate oxide grown.

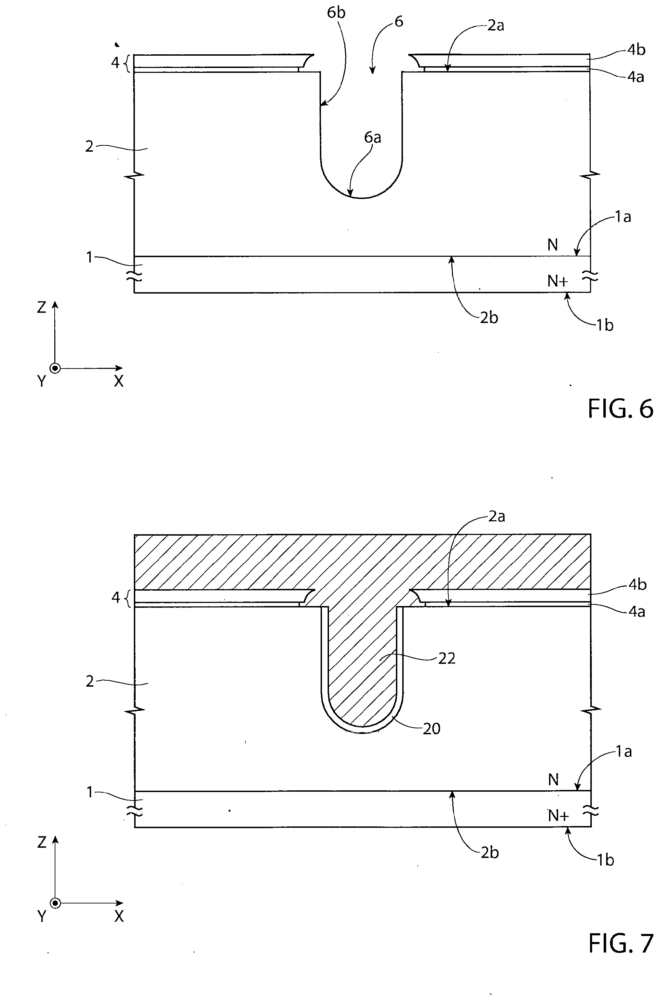

Then, Figure 6, complete removal of the sacrificial oxide layer 14 and of the third layer 4c is achieved by a further wet etching using a chemistry that selectively removes the silicon oxide and leaves the silicon nitride unaltered (or minimally altered). The first layer 4a may also be partially etched during this step, resulting in an underetch of the first layer 4a below the second layer 4b.

Then, Figure 7, a step of formation, for example by thermal oxidation, of a gate dielectric layer 20 on the walls 6a, 6b of the trench 6 is carried out.

Next, a layer of doped polysilicon 22, having the first conductivity type (N) is deposited within the trench 6 and on the gate dielectric layer 20; the polysilicon is deposited also on the wafer surface, in particular on the second layer 4b of SiN. A subsequent Chemical-Mechanical-Polishing (CMP) step, not shown, is carried out for removal of the layer of doped polysilicon 20 from the front of the wafer, laterally to the trench 6. The second layer 4b is used as stopping layer for the CMP step.

Processing of the wafer may then continue (not shown) in a known way, to form further electrical structures, including body, source and drain regions, as well as metallization regions for biasing the gate, body, source and drain regions.

In the process described above, the growth of the gate dielectric layer should be carried out on a clean silicon surface of the trench and without any obstacle due to the presénce of the second layer 4b of SiN; however, the moment, in the process flow, at which the second layer 4b is removed is crucial and depends by many factors: the second layer 4b cannot be removed before the polysilicon CMP step, because it acts as stopping layer for the CMP and therefore it protects the gate dielectric layer; the removal of the second layer 4b, as well as the final shape of the second layer 4b, are also a consequence of the steps of removing the sacrificial oxide layer and the third layer 4c, as discussed above (in the described process, the lateral erosion of the second layer 4b after a partial or total sacrificial oxide removal, is performed through an isotropic etch, which acts faster from the bottom side, generating a profile of the second layer that is detrimental for the later gate dielectric growth).

The lateral recession of the layer 4b is an isotropic wet etching process, with acts in all the direction of the space, including the bottom surface, resulting in a negative tapered profile, as shown in the drawings. In addition, the oxides of the layers 14 and 4c, partially removed before removal of layer 4b, have a different density and composition: the sacrificial oxide of layer 14 is a thermally grown SiO₂, while the oxide of the layer 4c is a Tetraethyl Orthosilicate (TEOS), deposited by Chemical Vapor Deposition (CVD) and then densified. The isotropic wet etch of the silicon nitride of layer 4b has an initial deoxidation step based on HF chemistry, which acts differently on thermal oxide and on the CVD densified oxide. The wet etch rate on the sacrificial oxide layer 14 has been demonstrated slightly higher respect to the one on densified TEOS, so that the bottom surface of the layer 4b is uncovered even faster respect to the top surface of the same layer 4b. Hence, the consequence is that the wet etch step of the layer 4b is more aggressive on the uncovered bottom side of the layer 4b and the etch proceed faster at the bottom side of the layer 4b than at the top side of the layer 4b, so that the final profile is negatively tapered, as shown, which is undesired.

Consequently, there is the need for a process of manufacturing an electronic device that improves the above-described process.

According to the present invention, a method for manufacturing the semiconductor electronic device is provided, as defined in claim 1.

For a better understanding of the present invention, preferred embodiments thereof are now described, purely by way of non-limiting example, with reference to the attached drawings, wherein:
Figures 1-7 illustrate, in lateral sectional view, manufacturing steps for the production of a semiconductor electronic device with trench-gate region, according to an embodiment that is not part of the present invention; and
Figures 8-13 illustrate, in lateral sectional view, manufacturing steps for the production of a semiconductor electronic device with trench-gate region, according to an embodiment of the present invention.

According to the present invention, a power device is provided, in particular a MOS transistor, or IGBT, with source electrode at a front side of the device, a drain electrode at a back side of the device, and a trench gate that extends from the front side towards the back side.

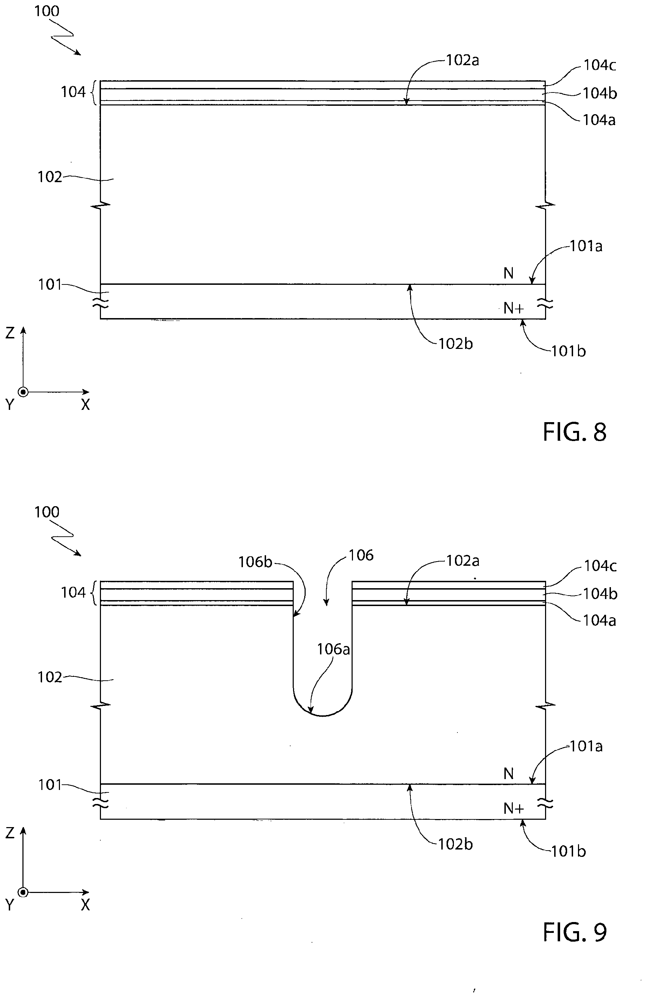

Figures 8-13 illustrate the electronic device during subsequent manufacturing steps, in lateral sectional view and in a system of spatial coordinates defined by mutually orthogonal axes X, Y, and Z.

In particular, the present disclosure describes exclusively the manufacturing steps of interest for the invention (i.e., regarding formation of a trench gate). Further elements of the electronic device (e.g., edge regions or other electrically active or non-active structures), which are of a per se known type, are not described and illustrated.

Figure 8 illustrates a wafer 100 comprising a substrate 101, in particular of silicon or silicon carbide or other semiconducting material, having a first conductivity (here, of an N type) and a first doping concentration (e.g., higher than 10¹⁹ at./cm³). The substrate 101 is delimited by a first side 101a and by a second side 101b opposite to one another along the axis Z.

On the substrate 101, a structural layer or region 102 is formed, for example by epitaxial growth of silicon (or other semiconducting material), having the first conductivity (N) and a concentration of dopants lower than that of the substrate 1 (e.g., comprised between 1.10¹⁵ and 5.10¹⁶ ions/cm³). Other dopants concentrations may be used, for example equal to that of the substrate 101 or higher than that of the substrate 101. The structural region 102 has a thickness, along Z, that is chosen according to the need on the basis of the voltage class in which the electronic device is to operate (e.g., 750 V), and is, for example, comprised approximately between 700 µm and 800 µm.

The structural region 102 is delimited by a first side 102a and a second side 102b opposite to one another in the Z direction. The second side 102b of the structural region 102 coincides with the first side 101a of the substrate 101.

According to alternative embodiments (not illustrated), one or more further structural regions, which are, for example, grown epitaxially analogously to the structural region 102, may be formed on the first side 101a of the substrate 101.

On the first side 102a of the structural layer 102, a multilayer 104 is then formed, which includes: a first covering layer 104a, in contact with the first side 102a, made, for example, of silicon oxide (in particular, SiO₂) grown via thermal oxidation with a thickness comprised between 5 nm and 10 nm; a second covering layer 104b, on top of the first layer 104a, made, for example, of a silicon nitride (in particular, Si₃N₄ or Si₂N₃) with a thickness comprised between 10 nm and 20 nm; and a third covering layer 104c, on top of the second layer 104b, made, for example, of TEOS with a thickness comprised between 300 nm and 500 nm. In one exemplary embodiment, the second layer 104b is in direct contact with the first layer 104a, and the third layer 104c is in direct contact with the second layer 104b.

The first layer 104a is, in particular, in direct contact with the structural layer 102 and has the function of forming an adhesion interface between the structural layer 102 and the second layer 104b, in order to prevent mechanical stress induced by the material of the second layer 104b on the material of the first layer 104a; further, it prevents nitridation of the surface of the silicon, which may jeopardises the operation of the device. The second layer 104b forms a hard mask for subsequent etching steps; it also has the purpose to prevent oxidation where not needed as well the erosion of the silicon itself during a subsequent Chemical Mechanical Polishing process.

As represented in Figure 9, by a photolithographic technique, the multilayer 104 is removed in regions of the wafer 100 where respective trenches 106 for the gates are to be formed. Then etching of the gate trenches is for example of a dry type (for example RIE, or DRIE, or any other etching technique). Techniques that allow formation of deep trenches 106 (of at least 5µm of depth along the Z direction from the surface 102a) with vertical sidewalls and minimal or no under-etch below the multilayer 104 are a choice that falls within the present disclosure. Selective removal of portions of the structural layer 102 exposed through the multilayer 104 allows to form the trench 106 delimited by a bottom wall 106a and sidewalls 106b. The trench 106 has a depth, measured from the first side 102a of the structural layer 102 comprised, for example, between 4 and 6 µm.

In top plan view on plane XY, the trench 106 may be strip-shaped, with main extension along the axis Y ranging from a few microns to a few millimetres, and a width, along the axis X, comprised between 0.5 µm and 1.5 um. Other layouts may be envisaged for the trench 106; for example, it may have, on the plane XY, a generically polygonal shape.

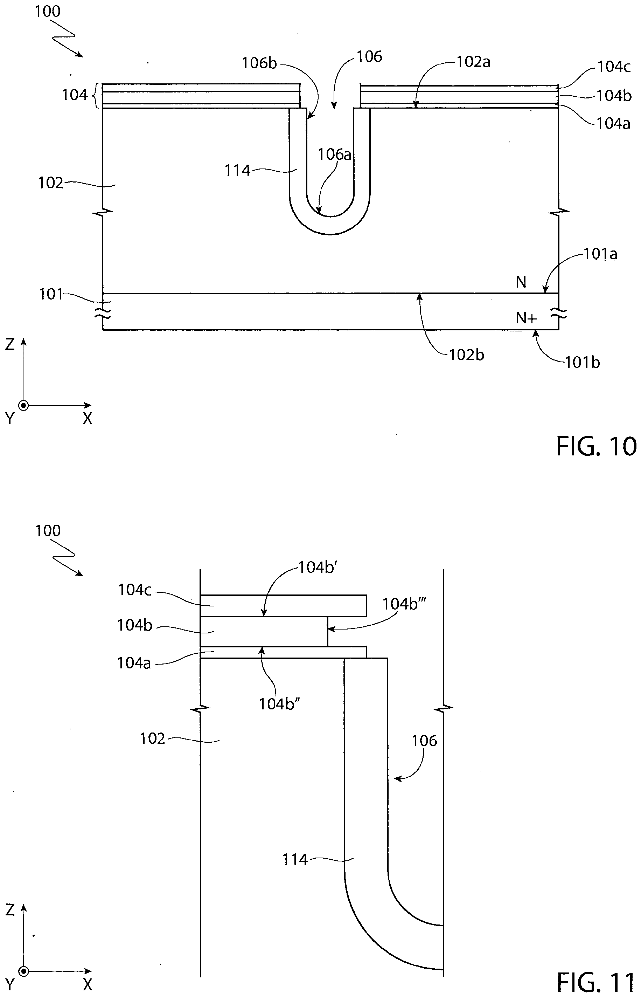

Next, Figure 10, a thermal oxidation process is carried out, to form a sacrificial oxide layer 114 within the trench 106, on the bottom wall 106a and the sidewall 106b. The formation of the sacrificial oxide layer 114 involves partial oxidation of the silicon material exposed within the trench 106, which is converted into a corresponding oxide (SiOa). Later removal of this sacrificial oxide layer 114 allows to smoothen the walls 106a, 106b, which might have been rendered rough and/or damaged by the etching step.

Next, Figure 11 (which is an enlarged view of a portion of Figure 10), before etching the sacrificial oxide layer 114 within the trench 106, a step is carried out to partially etch (recess) the second layer 104b. A wet etch is carried out using an etching chemistry that selectively removes the material of the second layer 104b (silicon nitride) while leaving substantially unaltered the materials of the sacrificial oxide layer 114 and of the third layer 104c. For example, a solution including phosphoric acid can be used.

Since the second layer 104b is sandwiched between the first and the third layer 104a, 104c, the liquid (wet) etching solution etches the second layer 104b from the exposed lateral sides, and penetrates between the first and third layers 104a, 104c as the material of the second layer 104b is removed (in particular laterally, or from a side).

The goal of this process step, which can be referred to as "pullback" step, is to produce a lateral recession of the second layer 104b, with the aim to leave the top corners (in one embodiment, of silicon material) of the trench 106 uncovered during the gate dielectric growth. Since the top side 104b' and the bottom side 104b" of the second layer 104b are protected by the first and respectively the third layers 410a, 104c, the etching acts only on the exposed lateral side 104b of the second layer 104b, avoiding the formation of the undesired negatively tapered shape shown in Figure 5B.

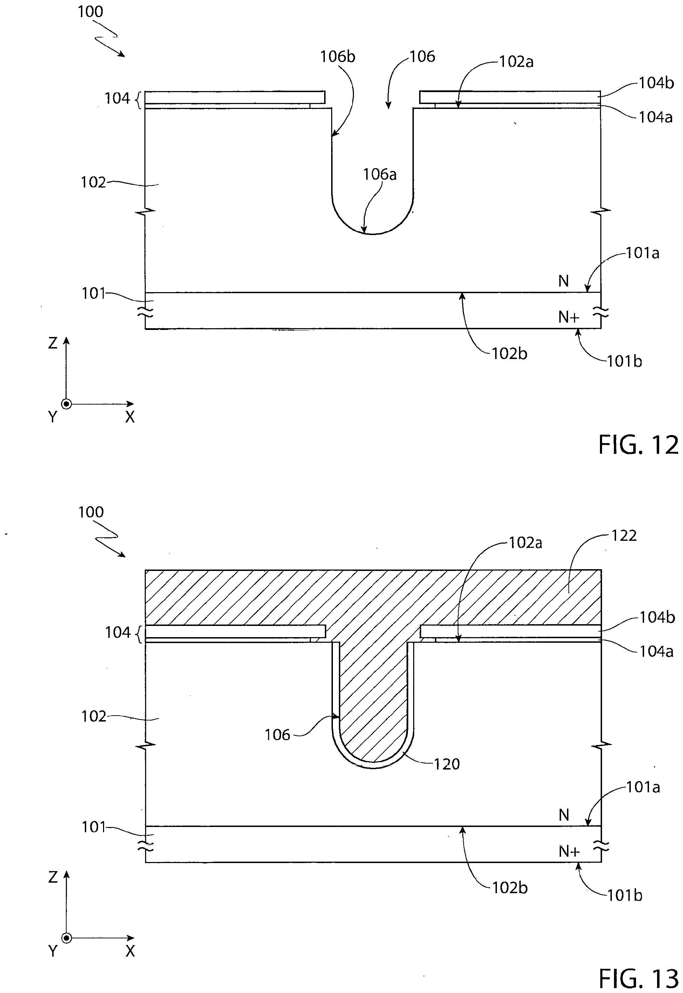

Then, Figure 12, the sacrificial oxide layer 114 within the trench 106 and the third layer 104c are completely removed at the same time, in one single etching step. The first layer 104a may also be partially removed during this step. Hydrofluoric acid (HF) may be used to perform this etching step.

Then, Figure 13, a step is carried out to form the gate dielectric layer 120 within the trench 106, for example by thermal oxidation or CVD deposition. The gate dielectric covers, in particular uniformly, the bottom wall 106a and the sidewalls 106b of the trench 106. The gate dielectric layer 120 has, for example, a thickness comprised between 90 nm and 120 nm.

Then, a layer of doped polysilicon 122, having the first conductivity type (N), and a doping level comprised between 10¹⁸ at/cm³ and 10²¹ at/cm³ is formed (e.g., deposited) within the trench 106 on the gate dielectric layer 120 and, in general, on the front of the wafer 100 (in particular, on the second layer 104b). A subsequent Chemical-Mechanical-Polishing (CMP) step is carried out to remove the layer of doped polysilicon 122 from the front of the wafer 100, except for the trench 106. The second layer 104b has the function of a stopping layer for the CMP step. Other removal process may be used, as known in the art.

In one optional aspect of the invention, to reduce an undesired erosion of the wafer 100 during the CMP process, it is advisable to decrease as much as possible the mechanical component and to amplify as much as possible the chemical contribute of the CMP chemistry (slurry), which has to be highly selective. For example, it is possible to choose the slurry among those available on the market. The chemical contribute of the slurry allows to better control the material erosion and its selectivity (by means the stoichiometry of the chemical reaction) with respect to the mechanical erosion provided by the pad and diamond disks, which act only as grinders. Such unbalancing can be obtained by reducing as much as possible the pressure value in the process recipe of the above-mentioned hardware parts, aiming to softly erode the wafer. A possible second option is to tune the chemistry composition of the slurry flown during the CMP process, which has to be highly selective.

When a slurry selective toward the oxide is not available, to match the criteria to leave the gate dielectric (here, of SiO₂) unaltered, the present solution envisages, in another optional aspect, the usage of a slurry highly selective toward the silicon nitride of the second layer 104b, for example using a material based on calcinated of Cerium Oxide having a property of enhancing the polysilicon removal rate. Cerium Oxide has a pH value between 7 and 9 and it is able to remove polysilicon material, reducing the reaction towards the silicon nitride. Another way to unbalance the chemical effect with respect to the mechanical one is the increasing of the temperature, which acts as enabler of the kinetic reaction. In such conditions, after the complete polysilicon removal, the consumption of the landing silicon nitride is very limited, and the gate dielectric underneath remains untouched and not damaged.

Keeping the SiN as stopping layer improves the whole process integration because, during the gate dielectric growth, it provides a mechanical resistance creating a waved horizontal silicon profile and a rounded silicon corner on top of the trench 106, which are preferred shapes to reduce wafer stresses and improve electrical performances of the device thus manufactured.

Then, in a way that is not shown in the drawings, body regions, having the second conductivity (P), are formed by known techniques of implantation of dopant species laterally to the trench 106, and thermal diffusion/activation, as well as one or more source regions, having the first conductivity (N), within the body regions.

Processingof the wafer 100 may then continue with deposition of pre-metallization dielectric, etching of the latter for opening electrical contacts by photolithography so as to reach and expose respective surface portions of the gate electrode and of the source regions, respective depositions of one or more metal layers that contact the gate electrode and the source regions, and photolithographic definition of said metal layers for completing formation of the source and gate electrodes. A further deposition on the back of the wafer (on the second side 101b of the substrate) enables formation of a drain metallization.

The gate and source metallizations are formed by depositing conductive material on the wafer 100. Likewise, also the drain metallization is formed by a step of deposition of conductive material, in particular metal, on the back of the wafer 100, thus completing formation of the drain terminal.

A vertical-conduction electronic device is thus formed. In operation, an electric current flows vertically (along Z direction) from the source regions to the drain metallization, through the structural region 102 and the substrate 101.

The electronic device 40 according to the present invention is, by way of example, one of the following: a vertical-conduction power MOS transistor, a power IGBT, or an MCT (MOS-Controlled Thyristor). Other applications of the disclosed process may be envisaged, according to needs.

From an examination of the characteristics of the disclosure provided according to the present invention the advantages that it affords are evident.

In particular, the invention allows to:
apply the state of the art in term of equipment for 300 mm wafers, able to guarantee the best performance on term of non uniformity, dimension and vertical profile (undercut free) control and stress;
integrate all the developed technology step in the aim to obtain a consistent process flow in term of electrical functionality, morphological results and cost saving;
obtain a robust process flow for prototype and manufacture of transistor lots.

Finally, it is clear that modifications and variations may be made to what has been described and illustrated herein, without thereby departing from the scope of the present invention, as defined in the annexed claims.

In particular, even though the description explicitly refers to silicon materials and its oxides, the present disclosure may be readily adapted to other semiconductor materials and respective oxides.

Moreover, the steps of forming the body regions and the source regions may be carried out (and are usually carried out) before the steps of forming the trench 106, so that the body regions and the source regions becomes self-aligned with the lateral sides of the trench 106 once the latter is formed.

## Claims

1. A method for manufacturing an electronic device, comprising the steps of:
- forming, on a first side (102a) of a solid body (101, 102) of semiconducting material, a first covering layer (104a) of a first oxide of said semiconducting material;
- forming, on the first covering layer (104a), a second covering layer (104b) of a nitride of said semiconducting material;
- forming, on the second covering layer (104b), a third covering layer (104c) of a second oxide of said semiconducting material;
- forming a passing opening through the first, second and third covering layers (104a-104c), exposing a portion of the first side (102a) of the solid body (101, 102);
- forming a trench (106) at the exposed portion of the solid body, said trench extending within the solid body towards a second side (101b), opposite to the first side along a first direction (Z), of the solid body;
- grow a sacrificial layer (114), of said first oxide, within the trench (106); and
- perform in the order:
selectively etch part of the second covering layer (104b),
completely remove the sacrificial layer (114) and the third covering layer (104c) in one or more contextual etching steps.

2. The method of claim 1, further comprising the steps of:
- forming, within the trench (106) a gate dielectric layer (120);
- forming, within the trench (106) and on the gate dielectric layer (120), a gate conductive region (122), wherein forming the gate conductive region (122) includes:
depositing conductive material within the trench and on the second covering layer (104b), and
performing a CMP process to remove the conductive material on the second covering layer (104b), using the second covering layer (104b) as a stopping layer for the CMP process.

3. The method of claim 2, wherein the CMP process is performed using a slurry highly selective towards the material of the second covering layer (104b).

4. The method of claim 2 or 3, wherein the CMP process is carried out in such a way that the chemical erosion of the conductive material on the second covering layer (104b) prevails over the mechanical erosion of said conductive material.

5. The method of anyone of the preceding claims, wherein the semiconductor material is silicon; the first oxide is silicon oxide, SiO₂; the second oxide is TEOS; the nitride material is a silicon nitride.

6. The method of anyone of the preceding claims, wherein the second covering layer (104b) has a top side facing the third covering layer (104c), a bottom side facing the first covering layer (104a) and a lateral side connecting the top side and the bottom side, the lateral side being fluidically accessible through said passing opening,
and wherein selectively etch part of the second covering layer (104b) includes perform a wet etching of the second covering layer (104b) at said lateral side.

7. The method of anyone of the preceding claims, wherein grow the sacrificial layer (114) includes perform a thermal grow process.

8. The method of anyone of the preceding claims, wherein forming the trench (106) includes etching the solid body for a thickness, along the first direction (Z), between µm 4 and 10 µm, ending within the solid body.

9. The method of anyone of the preceding claims, further comprising forming a body region laterally to the trench (106) and a source region within the body region; and forming a drain contact at the bottom side of the solid body.

10. The method of anyone of the preceding claims, wherein the device is in the group comprising: a vertical-conduction MOS transistor, a IGBT, an MCT.
